# EUROPEAN PATENT APPLICATION

(11) **EP 1 383 359 A2**
(43) Date of publication of application: **21.01.2004**
(21) Application number: 03077226.3
(22) Date of filing: 17.07.2003
(51) Int. Cl.: H05H 1/24

(54) **Method and arrangement for treating a substrate with an atmospheric pressure glow plasma (APG)**

(30) Priority: 19.07.2002 US 198740
(71) Applicant: Fuji Photo Film B.V., 5047 TK Tilburg (NL)
(72) Inventor: van de Sanden, Mauritius Cornelius Maria, 5017 JC Tilburg (NL); Aldea, Eugen, 5616 GK Tilburg (NL); Mori, Fuyuhiko, 5045 SH Tilburg (NL); de Vries, Hindrik Willem, 5045 CM Tilburg (NL)
(74) Representative: Valkonet, Rutger

(57) **Abstract**

Method and arrangement for generating an atmospheric pressure glow (APG) plasma (1), wherein the plasma (1) is generated in a discharge space (10) between a plurality of electrodes (3, 4). A dielectric (2) is present on at least one of the electrodes (4), which dielectric (2) has a boundary surface with the plasma (1) enabling interactions between the plasma (1) and the boundary surface of the dielectric (2). The dielectric (2) is arranged for releasing electrons contributing to the plasma (1) from the boundary surface by the interactions.

## Description

### Field of the invention

The present invention relates generally to a method for generating an atmospheric pressure glow plasma (APG), and in particular to a method wherein said plasma is generated in a discharge space between a plurality of electrodes, and wherein a dielectric is present on at least one of said electrodes, said dielectric having a boundary surface with said plasma enabling interactions between said plasma and said surface, wherein said dielectric is arranged for releasing electrons contributing to said plasma from said surface by said interactions.

The present invention further relates to arrangement for generating an atmospheric pressure glow plasma (APG), comprising a discharge space substantially located between a plurality of electrodes for generating a plasma, at least one of said electrodes comprising a dielectric attached such that a boundary surface between said dielectric and said discharge space is arranged for enabling interactions between said plasma and said surface, wherein said dielectric is arranged for releasing electrons contributing to said plasma from said surface by said interactions.

### Background of the invention

Modification or treatment of a surface by applying glow plasma is a known technique in industries, such as photo film production industry, used in order to improve certain surface and material properties. For instance, in the production of photo film, a thermoplastic polymer film (triacetyl cellulose (TAC), polyethyleneterephthalate (PET), polyethylene-naphthalate (PEN) or similar) is prepared using a glow plasma in order to improve adhesion properties of the surface.

Plasma is considered generally as a suitable solution for material processing, because it generates a large flux of reactive species (radicals, ions), which can be directed to the process zone and manipulated to the desired shape by using an appropriate electric field distribution. Plasma treatment would have considerable advantage if it could be generated at atmospheric pressure, and in the presence of air. Advantages of using atmospheric pressure are a larger density of reactive species than in the low pressure case, and the advantage of avoiding vacuum technology. The advantages of using air instead of other gasses is the fact that it is cheap and readily available.

Another desired feature of atmospheric pressure glow plasmas (APG) is the generation of these plasmas at low temperatures around 300-400 K. This will make the technology applicable to the treatment of thermoplastic polymer surfaces, as is common in photo film production methods.

Generating a plasma under the above circumstances is not a straight forward technique. At atmospheric pressure, the particle density is high and as a result the mean free path of reactive species is small. The processes of excitation and ionisation are restricted to a limited area, and the plasma is generated primary in a filamentary form.

To generate a uniform plasma, one must first have a uniform breakdown and secondly one must maintain it. In both of these steps major instabilities like streamer breakdown for the breakdown phase and filamentation due to glow to arc transition in the post-breakdown phase may occur. To generate a homogeneous glow, both instabilities must be avoided.

Plasmas at atmospheric pressures are very unstable and will tend to go into a spark or an arc in short time after the breakdown. Any random local increase in a current density will tend to grow rather than to be damped and plasma will be constricted.

Transition to spark or arc can be prevented only by limiting the current density to very low values (below 0.1 mA/cm²) and by the plasma duration to a few microseconds. But in this way, due to the limited plasma energy, the use of such "strangled" atmospheric plasmas for material processing is inefficient. The simplest solution to limit the current density and plasma duration is to cover the electrodes with a dielectric (dielectric barrier discharge configuration, DBD). As a result of this, the charges are accumulated on the surface of the dielectric, reducing the value of the voltage applied to the plasma. When the magnitude of the voltage applied to the plasma decreases below a critical level (the cut-off voltage), the plasma can not be sustained any longer. As a result, the duration of the plasma is limited.

The dielectric barrier discharge however has a rather limited efficiency in limiting the current density. At atmospheric pressure, plasma varieties like streamers having current densities in the range of 10 A/cm² can still be generated on small surface areas. The dielectric barrier discharge can limit only rate of production per unit of surface of such high current density plasmas.

A problem related to generation of atmospheric pressure plasmas is that high electric fields 30-40 kV/cm and high voltages are required for plasma ignition. The use of these high voltages is required to generate and maintain the plasma, because electron emission from the cathode surface via ion bombardment or photo ionisation processes, is very small. As a result, most of the atmospheric pressure plasmas are generated through a mechanism known as streamer formation. Streamers are short life, high electron density, filamentary plasmas. The generation of such high current density plasmas has a malign effect on the quality of material processing using atmospheric pressure plasmas.

### Summary of the invention

It is an object of the invention to provide a method for generating a uniform atmospheric pressure plasma, preferably at temperatures around room temperature.

In a first aspect according to the present invention, there is provided a method for generating an atmospheric pressure glow plasma (APG), wherein said plasma is generated in a discharge space in an electric field between at least a pair of electrodes, and wherein a dielectric is present on at least one of said electrodes, said dielectric having a boundary surface with said electric field enabling interactions between said electric field and said surface, wherein said dielectric is arranged for releasing electrons contributing to said plasma from said surface by said interactions.

It has been observed that by providing a boundary surface between the electric field for generating the plasma and the dielectric, and arranging said dielectric such that electrons are released by interactions between the surface and the electric field, the stability and uniformity of the plasma are greatly enhanced. Note that due to the above effect, the voltage applied to the electrodes can be kept relatively low to reduce the probability on occurrence of streamer formation or transition from glow to arc. A number of properties of said dielectric have been identified and a large variety of materials that may be used to form the dielectric have been discovered and will be described below, corresponding to various embodiments of the invention.

Generating a plasma requires the supply of sufficient energy to a gas such that the gas is ionised. Within the plasma, collisions and interactions between elements of the gas create chemically or physically active species, such as metastables, ions, electrons, and others. Recombinations and transitions of excited elements to their ground state also causes the emission of photons from the plasma.

These chemically and physically active species may also be present in the electric field which is adjacent to said dielectric. It has been observed that interactions between the electric field and a suitably chosen dielectric (which dielectric will be described below), provides a suitable source for electrons contributing to the plasma. Due to this extra source of electrons, it becomes possible to reduce the voltage applied to the electrodes for forming the plasma. In turn, this contributes to the stability of the plasma.

More specific, for the plasma to sustain, sufficient free electrons should be present in the plasma. For obtaining a homogenous atmospheric plasma a solution is the generation of a background pre-ionization, implying that sufficient seed electrons must be present in the reactor before the plasma breakdown. These seed electrons can be created as described above, through interactions within the plasma itself or can be generated as a result of a interaction between the species present in the electric field and the boundary surface with the dielectric. It is observed that under the right conditions the required background pre-ionization can be generated at the surface level, such that said dielectric contributes substantially to the plasma by providing electrons to the electric field. These electrons contribute to the plasma, such that under said right conditions, a homogeneous uniform atmospheric glow discharge plasma having temperatures around room temperature is created. Since the dielectric surface becomes an important source of electrons for the plasma the applied voltage to the electrodes may be reduced, reducing in turn the probability on streamer formation. This enables the possibility of providing a stable uniform plasma at relatively low voltages.

In an embodiment of the invention, said interactions comprise interactions between said plasma and said surface.

It will be understood that embodiment provides benefits since the plasma itself is a source of these chemically and physically active species. A concentration of said species will be present in said plasma and interactions between the dielectric and said plasma will therefore be an efficient source of electrons contributing to said plasma.

Note that the presence of electrons near the boundary surface of the dielectric may be enhanced by an embodiment of the invention, wherein said dielectric has a further surface contiguous to at least one electrode of said pair of electrodes for providing electrons to said dielectric.

In this embodiment, free electrons present in the (conducting) electrode may more easily reach the boundary surface of the dielectric with the electric field. As will be appreciated by the person skilled in the art, the more electrons that are present near the surface of the dielectric the more electrons are provided to the electric field due to said interactions.

Another solution for obtaining a homogenous atmospheric glow plasma is to generate a large number of secondary electrons at the surface in contact with the electric field, and according to the embodiment described above. The use of lower voltages substantially decreases the space charge in the plasma and thus the probability of streamer breakdown and glow to arc transition. The probability of generating secondary electrons (Townsend coefficient γ) is high under the right conditions and as a result of a single primary electron avalanche a large number of secondary avalanches can be generated in the discharge space, generating a uniform plasma. In order to achieve the high γ values, it has been observed that, according to an embodiment of the invention, the dielectric used for generating said APG may have surface regions comprising a low work function.

The work function is here defined as the energy required to knock out an electron near the surface of the dielectric such that it has just enough energy to overcome the potential barrier and end up out of surface without having kinetic energy. A dielectric surface comprising regions where the work function is low or at least comparable to the energy that can be transferred by species present in the plasma, may release sufficient numbers of electrons to sustain a stable homogeneous uniform APG.

The dielectric that is used may be arranged to optimise the creation of free electrons through any of the following mechanisms, for which a number of physical and chemical properties of the dielectric material used are important.

Note that the dielectric that is used may be chosen such that the plasma may be uniform or quasi-uniform during the first voltage pulse with an amplitude higher than the breakdown voltage. This requirement is settled for a number of dielectrics discussed below, under different circumstances (e.g. embodiment A).

### Embodiment A.

In an embodiment of the present invention the dielectric material together with the applied electric field, the interelectrodic gap, the current density, the plasma frequency and the dielectric thickness, are arranged for maximizing the electron field emission by giving the electrons the energy which is sufficient to overcome the potential barrier at the surface level and said discharge space under the influence of the applied electric field and of the electric field generated by the electrons formed in plasma and located at the dielectric surface boundary.

| *Required material*/*plasma properties* | |
|---|---|
| Applied Electric field: | 1-100 kV/cm |
| Interelectrodic gap: | 0.1-10 mm |
| Current density: | ≤ 10 mA/cm² |
| Charge per unit of surface: | ≥ 0.001-100 nC/cm² |
| Dielectric thickness: | 10 - 1500 µm |
| Pulse frequency: | 1 kHz - 1 MHz |
| Temperature of dielectric: | ≤ 100 °C |

At least 10 ppm of the surface area may have a work function lower than 0.2 eV. In the low work function regions of the surface the applied electric field may be locally intensified by the combination of the electric charge located at the surface boundary and the surface roughness to values of at least 100 kV/cm. The background pre-ionization generated by the electrons emitted by the surface through field emission may have a value of at least 1 nA/cm².

### Embodiment B.

In another embodiment of the present invention the dielectric in contact with the plasma is arranged for enabling thermo-electronic emissions of electrons at operating temperature. The background pre-ionization generated by the electrons emitted by the surface through thermo-electronic emission may have a value of at least 1 nA/cm². The temperature will be 20-80 °C. The current density may be smaller than or equal to 10 mA/cm².

### Embodiment C.

In another embodiment of the present invention the dielectric used together with the applied electric field, AC pulse repetition frequency, and the interelectrodic gap are arranged for releasing electrons from said surface under influence of interactions which interactions comprise interactions between photons from said plasma and electrons located at the surface level.

### Required material/plasma properties

The probability of secondary photo-ionisation (Townsend γ coefficient) may be higher than 0.1.

| | |
|---|---|
| Applied Electric field: | 1-100 kV/cm |
| Inter-electrode gap: | 0.1-10 mm |
| current density: | ≤ 10 mA/cm² |
| Charge per unit of surface: | > 0.001 - 100 nC/cm² |
| Pulse frequency: | 10 kHz - 1 MHz |

### Embodiment D.

In another embodiment of the present invention the applied power, the pulse frequency and the dielectric used are arranged for releasing the electrons from said surface under influence of interaction which interactions comprise collisions between metastable species and electrons present in said dielectric near said surface. Metastable species are formed in said plasma and may reach the dielectric surface. The interaction between metastables and electrons is intensified by the generation of high electric fields near the surface of the dielectric.

| *Required material* /*plasma properties* | |
|---|---|
| Applied Electric field: | 1-100 kV/cm |
| Inter-electrode gap: | 0.1-1 mm |
| current density: | ≤ 10 mA/cm² |
| Charge per unit of surface: | > 0.001 - 100 nC/cm² |
| Pulse frequency: | 10 kHz - 1 MHz |
| Dielectric thickness: | 10 - 1500 mm |

The applied electric field may be locally intensified to at least 100 kV/cm by the combination of the electric charge located at the boundary surface and the surface roughness values. The background pre-ionisation generated by the electrons emitted by the surface through field emission may have values of at least 1 nA/cm².
The lifetime of the excited molecular states should be much longer than the pulse repetition period. The AC voltage frequency may than be in the range of 10kHz-1MHz. Due to the presence of these excited molecular states, combined with a high electric field, the probability of secondary ionisation (Townsend γ coefficient) may be increased above 0.1. The current density should be in the range of 0.1 mA/cm² to 10 mA/cm².

It has further been observed that by using dielectric materials such as polyesters, fluoro polymers, ceramics or combinations of these in said dielectric, the stability and properties of the plasma improve. It is in particular suggested to use polyethyleneterephthalate (PET), polyethylenenaphthalate (PEN), polytetrafluoroethylene (PTFE), triacetylcellulose (TAC), polyethylene (PE), ceramic such as silica (SiO₂) or alumina (Al₂O₃), or combinations of these.

In another embodiment of the present invention, the dielectric material is selected from the materials which intensify the applied electric field at the surface of said dielectric such that sufficient energy is provided to the electrons on the surface to overcome the potential barrier.

Examples of suitable dielectric material are micro porous polymers such as polyvinylidene fluoride, feroelectric polymer films, micro porous polyethylene, micro porous polypropylene, micro porous PEN, Methylcellulose membrane, cellulose acetate membranes, polytetrafluoroethylene membranes, Polyvinyl chloride, membranes, polyimides membranes, etc., and micro porous ceramics material.

| Required material/ plasma properties | |
|---|---|
| Applied Electric field | 1-100 kV/cm |
| Interelectrodic gap | 0.1-10 mm |
| Current density | 0.1-10 mA/cm² |
| Charge per unit of surface | > 1-100 nC/cm² |
| Dielectric thickness | 100-1500 micrometer |
| Pore size | 0.1-100 microns |
| Pulse frequency: | 1 kHz - 1MHz |

At least 10 ppm of the surface area may have a work function lower than 0.3 eV In the low work function regions of the surface the applied electric field may be locally intensified by the combination of the electric charge located at the surface boundary and the surface micro porosity to values of at least 100 kV/cm.

As explained above, APG's may be used to treat substrates. In many cases these substrates will be of dielectric material as well, for example treatment of polymer film surfaces.

It is thus within the spirit of this invention to apply the APG for various application such as in the surface activation processes which substrate can be glass, polymer, metal, etc. For the generation of hydrophobic or hydrophilic surfaces; in the chemical vapour deposition process where specific chemical compositions gasses such as SiH₄, hydrocarbons, organosilicons (TEOS, HMDSO, etc.) or organometallics are usually involved; in the chemical decomposition of gases containing volatile ozone component (VOC), in the removal of toxic compounds from the gas phase, in the increase of combustion degree of hydrocarbons, in the surface cleaning processes the of various substrate where sterilisation or dry cleaning purposes can be realised , in deposition processes of polymers and in deposition processes for oxidic materials.

In an embodiment of the invention, wherein said plasma is used for treating a substrate and the material used as a dielectric and said substrate are of a same or comparable chemical family. Both dielectric and substrate may even be of a same material, in the case of APG treatment for photo film production this material may, for example, be triacetyl cellulose (TAC), polyethyleneterephthalate (PET) or polyethylene-naphthalate (PEN).

One may even use, with respect to what is suggested above, another substrate sample to be treated for use as a dielectric. In this last case two substrate samples can be treated with an APG simultaneously.

In another embodiment of the invention, a gas is present in the discharge space and said gas comprises any element of a group comprising argon, nitrogen, oxygen, carbon dioxide, air, helium, NH₃ and combinations thereof. Also other gasses comprising specific chemical composition such as SiH₄, hydrocarbons, organosilicons (TEOS, HMDSO) which is usually involved in the chemical vapour deposition process, may be present in said discharge space.

It is observed that the plasma properties improve in the presence of these gasses. The effect can be enhanced by establishing a (continuous) gas flow through the discharge space.

It has been observed that a method provided by the invention can be used under the circumstances (with reference to the operation parameters) presented in the table below:

| Parameter | Description | Range | Optimum |
|---|---|---|---|
| U | AC voltage amplitude | 0.5 - 20 kV | 10% higher than breakdown voltage |
| f | AC voltage frequency | 1 kHz - 1 MHz | 10 - 500 kHz |
| D_{gap} | Gap distance between substrate and dielectric | 10 - 3000 µm | 250 - 1500 µm |
| φ_{vol, gas} | Volumetric gas flux of gas flow | 1 - 50 l/min | 10 l/min |
| d_{ε} | Thickness of the dielectric | 1 - 5000 µm | 250 - 500 µm |

The dielectric may be comprised of any of the following substances: triacetyl cellulose (TAC), polyethyleneterephthalate (PET), polyethylene-naphthalate (PEN), fluoro polymers (such as PTFE), aminopolymers (such as polyamide) ceramics (such as alumina (Al₂O₃), silica (SiO₂)). Materials containing electronegative species are also a preferred option.

It will be appreciated by those skilled in the art, that by moving the substrate, which may be a thermoplastic polymer film, through the discharge space past the plasma, this will have a positive effect on the efficiency of surface treatment. In case a second substrate film is used instead of a dielectric, as suggested above, both substrates may be moved through the discharge space, and will be treated simultaneously.

One may appreciate that the electrodes may be placed either in a coplanar configuration, wherein two or more electrodes are place near each other in a same plane adjacent to the discharge space, or the electrodes may be placed in an opposing configuration, wherein two or more electrodes may be located on either side of the discharge space, facing each other.

In a second aspect, the invention provides an arrangement for generating an atmospheric pressure glow plasma (APG), comprising a discharge space formed between a plurality of electrodes for generating a plasma, at least one of said electrodes comprising a dielectric attached such that a boundary surface between said dielectric and said discharge space is arranged for enabling interactions between said plasma and said surface, wherein said dielectric is arranged for releasing electrons contributing to said plasma from said surface by said interactions.

The present invention will now be further elucidated by a description and drawings referring to a preferred embodiment thereof, directed to the treatment of a substrate surface with an APG. The invention is not limited to the embodiments disclosed, which are provided for explanatory purposes.

### Brief description of the drawings

Figure 1 is a schematic drawing of an arrangement for carrying out a method according to the present invention;
Figure 2 is a drawing of an APG treatment device for treating substrate films.
Figure 3 shows an experimental set-up that may be used to analyse the effect of the plasma stability as a function of dielectric material.
Figure 4 shows the plasma current as a function of time for the experimental set-up shown in figure 3.

### Detailed description of the drawings

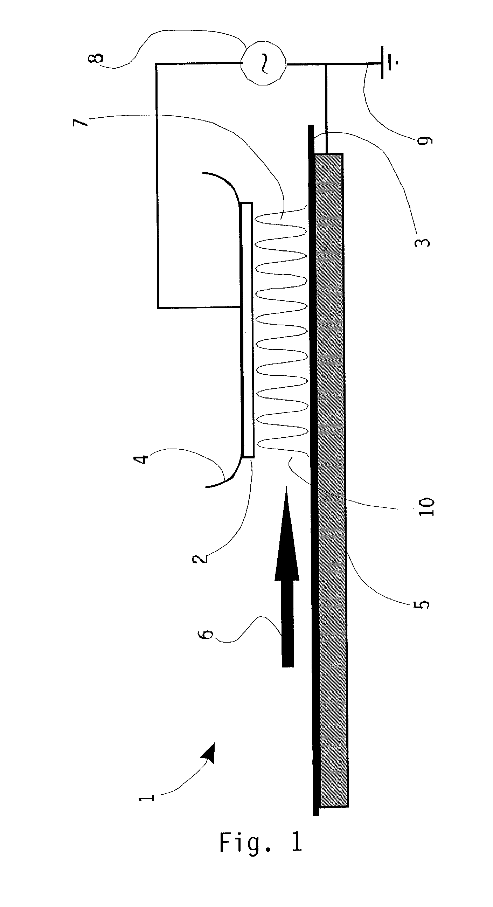

In figure 1 an arrangement for generating plasma 1 comprises a dielectric 2 connected to a first electrode 4. A second electrode 5, arranged for carrying a substrate film 3, is arranged on the opposite side of a discharge space 10. A gas flow 6 may be established parallel to the surfaces of said dielectric 2 and substrate film 3. First electrode 4 has been connected to an AC power supply 8, arranged for providing an AC voltage. Second electrode 5 has been connected to said AC power supply 8 as well as to ground 9.

In a method according to the present invention, a gas flow 6 may be established comprising one or more gasses such as argon, nitrogen, oxygen, carbon dioxide, Helium and NH₃ or any combination or mixture of these gasses. Surprisingly, it has been observed that with a method according to the present invention, the presence of substantial amounts of oxygen does not influence the plasma stability negatively.

After establishing a gas flow, the electrodes (4, 5) are energised by AC power supply 8. Power supply 8 will provide an AC voltage with an amplitude in the range of 0,5-10 kV, at frequency in the range of 1 kHz - 1 MHz (optimum 10-500 kHz). Upon reaching a break down voltage, which is dependent on, amongst others, the gas used and the properties of the dielectric 2, a plasma 7 will be generated between the dielectric 2 and the substrate film 3. Simultaneously, the substrate film 3 may be moved in any direction past the plasma in order to treat said film 3 along its full surface.

The dielectric 2 may comprise a material such as PET, PEN, PTFE or an ceramic such as silica (SiO₂) or alumina (Al₂O₃). Any combination or mixture may be used as well. In photo film production industry, the substrate film 3 may be a supporting film for a photo sensitive substance, which is treated with an APG plasma first, in order to improve its adhesion properties before adding said photo sensitive substance. Said bearer film may be any suitable polymer, but often materials such as PEN, PET, TAC, PE, or Polyolefin laminated paper will be used for this purpose.

The distance between the dielectric 2 and the substrate film 3, forming the discharge space 10, may be in the range of 0.1 - 5 mm, with an optimum distance of 250 - 1500 µm. The volumetric gas flux of gas flow 6 may be within the range of 1 l/min and 50 l/min, with an optimum around 10 l/min The thickness of dielectric 2 may be in a range of 1-1000 µm, with an optimum between 250 µm and 500 µm.

It has been observed that under the circumstances described above a stable plasma can be generated. The stability of the plasma is affected by the surface of the dielectric. It has been shown that some organic dielectrics, such as PEN or PET, provide a better plasma stability in comparison to other dielectrics used. A scientific explanation of this is not yet available. Very good results have been achieved in experiments where the dielectric 2 was chosen to be PEN, as well as the substrate film 3. Based upon this result, one may replace dielectric 2 by a second substrate film, with the additional benefit that two substrate films can be treated at the same time.

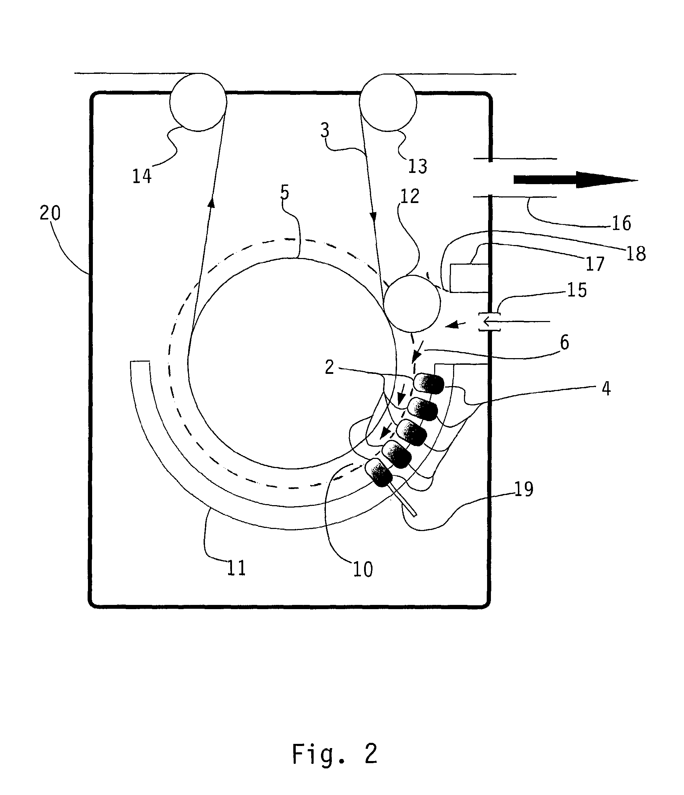

Figure 2 shows a device for treating a substrate film 3, such as a photo film. In this device, dielectric 2 has been coated on the surfaces of electrodes 4 forming the inside of a half circle around roll shaped electrode 5. Note that only a few electrodes 4 are shown in figure 2. Each electrode 4 is connected to a power supply (not shown) by connecting bar electrodes 19 at the back side of each electrode 4 to said power supply (note that only one bar electrode is shown). Electrodes 4 are attached to the device by electrode holder 11.

Via supporting roll 13 the substrate film 3 is brought inside treatment chamber 21 through the wall 20, and is lead past electrodes 4 via supporting roll 12 and roll shaped electrode 5. After treatment, substrate film 3 will leave the treatment chamber 21 via supporting roll 14 and an opening in the wall 20.

The discharge space 10, is formed by the gap between the dielectric 2 on the electrodes 4 and the substrate film 3 on roll shaped electrode 5. In use, a plasma will be generated between said dielectric 2 and said substrate film 3.

The APG treatment device, according to an embodiment of the present invention, further comprises a gas inlet 15 and a gas outlet 16 through which a gas can be blown into the treatment chamber 21 for establishing a gas flow 6 between dielectric 2 and substrate film 3. In order to prevent a direct gas flow between supporting roll 12 and wall 20 from the gas inlet 15 to the gas outlet 16, a wall 17 is attached to wall 20 and stretches out perpendicular to wall 20 in the direction of roll 12. The gap between the end of wall 17 and rotatable roll 12 is formed by a flexible wall 18, schematically drawn in figure 2. A gas flow 6 is as such forced to flow through discharge space 10.

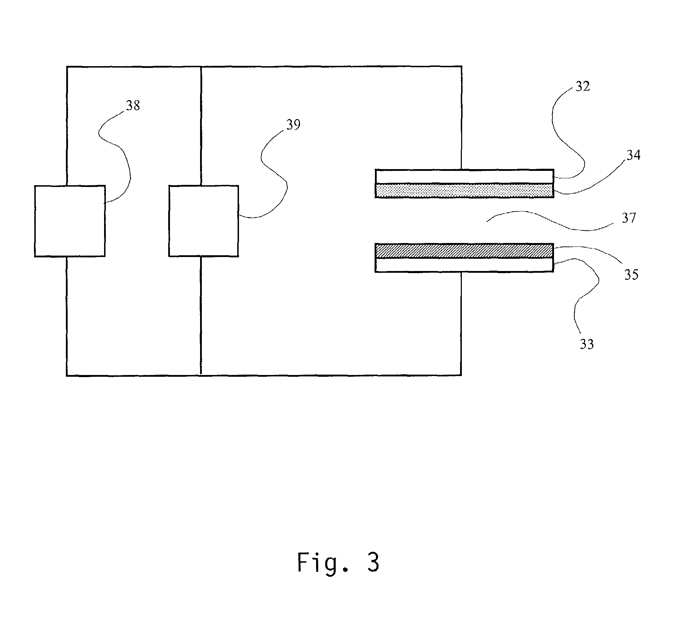

In Figure 3 an experimental set-up is shown that may be used to analyse the effect of the plasma stability as function of dielectric material. A dielectric material 32 may be a polyethylenenaphthalate (PEN) film which is attached to the conductive material 34, and a dielectric material 33 is ceramic/enamel, which is coated on the conductive electrode 35. The distance between said dielectric 32 and dielectric 33 is 1 mm.

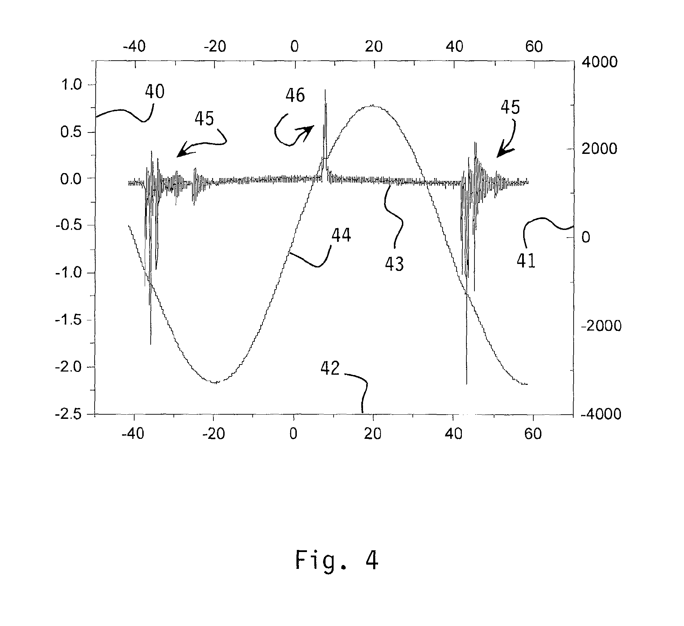

Nitrogen gas having a velocity of 2 m/sec is fed into the discharge space 37. The electrode is charged with an AC power supply having a voltage amplitude of 2.8 kV (V_{Peak}) and frequency of 13 kHz in order to generate plasma. The gap distance between the electrodes forming the dicharge space is 1 mm. By using an oscilloscope, an I-V characteristic of the plasma, as shown in the diagram of figure 4, may be detected. An additional LC network 39 may be added to improve the electrical properties of the experimental set-up.

As it is known, plasma is generated only at the cathode and since the current is alternating, the effect of the plasma stability as function of the PEN or ceramic/enamel dielectric material can be easily evaluated.

In figure 4, the plasma current 43, which is scaled on the left vertical axis 40 in A, is shown as a function of time in µs on the horizontal axis 42. The applied AC voltage 44 over the electrodes, scaled on the right vertical axis 41 in V, is shown in the diagram as a function of time 42 as well.

It can be seen in figure 4 that, for the above mentioned process condition, it is preferable to select PEN as a dielectric material instead of a ceramic or enamel, since it generates a more stable plasma compared to ceramic or enamel. This becomes evident when the current 45 of plasma generated with the enamel/ceramic covered cathode, is compared to the plasma current 46 related to the PEN cathode. The latter shows a single peak 46, which is lower and broader (in time) as compared to the plurality of short, sharp, high peaks 45 in plasma current achieved with the enamel/ceramic cathode. In case another process condition exists, where another gas is involved, a different result may be obtained. Hence a good selection of dielectric material and plasma process condition is always required.

For the purpose of comprehensiveness, it is noted here that numerous modifications and variations of the present invention are possible in the light of the above teachings. It is therefore understood that, within the scope of the amended claims, the invention may be practised otherwise than as specifically described herein.

## Claims

1. Method for generating an atmospheric pressure glow plasma (APG), wherein said plasma is generated in a discharge space in an electric field between at least a pair of electrodes, and wherein a dielectric is present on at least one of said electrodes, said dielectric having a boundary surface with said electric field enabling interactions between said electric field and said surface, wherein said dielectric is arranged for releasing electrons contributing to said plasma from said surface by said interactions.

2. Method according to claim 1, wherein said interactions comprise interactions between said plasma and said surface.

3. Method according to any of the previous claims, wherein said dielectric has a further surface contiguous to at least one electrode of said pair of electrodes for providing electrons to said dielectric.

4. Method according to any of the previous claims, wherein energy is transferred to said surface during said interactions, and wherein said surface of said dielectric used comprises at least one region having a work function smaller than the energy transferred to said surface during said interactions.

5. Method according to any of the previous claims, wherein said interactions comprise collisions between metastable species formed in said plasma and electrons present in said dielectric near said surface.

6. Method according to any of the previous claims, wherein said interactions comprise interactions between photons from said plasma and electrons present in said dielectric near said surface.

7. Method according to any of the previous claims, wherein said interactions comprise collisions between ions present in said electric field and electrons present in said dielectric near said surface.

8. Method according to any of the claims 5-7, wherein said electrons present in said dielectric near said surface comprise electrons bound to atoms at surface level.

9. Method according to any of the previous claims 4-8, wherein said surface comprises means for reducing the work function of atoms at surface level.

10. Method according to any of the previous claims, wherein said dielectric is arranged for providing sufficient energy to the electrons to overcome a potential barrier between said surface level and said discharge space, under the influence of said electric field present in said discharge space.

11. Method according to any of the previous claims, wherein said dielectric is arranged for enabling thermionic emission of electrons present in said dielectric near said surface, at operating temperature of said plasma.

12. Method according to any of the previous claims, wherein said dielectric is selected from a group comprising polyesters, fluoro polymers, ceramics, and combinations thereof.

13. Method according to claim 12, wherein said dielectric is selected from a group comprising triacetyl cellulose (TAC), polyethyleneterephthalate (PET), polyethylene-naphthalate (PEN), polytetrafluoroethylene (PTFE), ceramics such as SiO₂ or Al₂O₃, and combinations thereof.

14. Method according to any of the claims 12 and 13, wherein said dielectric is selected from a group micro porous polymers such as polyvinylidene fluoride, ferroelectric polymer films, micro porous polyethylene, micro porous polypropylene, micro porous PEN, Methylcellulose membrane, cellulose acetate membranes, polytetrafluoroethylene membranes, polyvinyl chloride membranes, polyimides membranes, micro porous ceramics material, combinations of these substances and similar substances.

15. Method according to any of the previous claims, wherein a gas is present in said discharge space, and wherein said gas comprises any element of a group comprising argon, nitrogen, oxygen, carbon dioxide, air, helium, NH₃ and combinations thereof.

16. Method according to any of the previous claims, wherein said plasma is used for treating a substrate, and wherein said substrate and said dielectric are of a same chemical family.

17. Method according to claim 16, wherein said dielectric and said substrate are of a same material.

18. Method according to any of the claims 16 and 17, wherein said dielectric is a further substrate which is treated with said plasma.

19. Method according to any of the previous claims, wherein said dielectric has a thickness of at least 100 µm and at most 3000 µm.

20. Method according to claim 19, wherein the thickness of said dielectric is in the a range of 250 µm - 500 µm.

21. Method according to any of the previous claims, wherein said discharge space has a dimension determined by a closest distance between said electrodes, wherein said dimension is in a range of 100 µm - 5000 µm.

22. Method according to claim 21, wherein said dimension of said discharge space is within a range of 250 µm - 1500 µm.

23. Method according to any of the previous claims, wherein said electric field is provided by applying an AC voltage to said electrodes, and wherein said AC voltage has a frequency within a range of 1 kHz - 1 MHz.

24. Method according to claim 23, wherein the frequency of said AC voltage is within a range of 20 kHz - 500 kHz.

25. Method according to any of the previous claims, wherein said plasma is generated by providing said electric field between said electrodes, and wherein the strength of said electric field is within a range of 1 kV/cm - 100 kV/cm.

26. Method according to any of the previous claims, wherein said gas present in said discharge space is a gas flow.

27. Method according to claim 26, a volumetric gas flux of said gas flow is within a range of 1 l/min and 50 l/min

28. Method according to any of the claims 26 and 27, wherein said volumetric gas flux is in a range of 5 l/min and 15 l/min

29. Method according to any of the previous claims, wherein said surface is maximized.

30. Method according to any of the previous claims, wherein said at least one pair of electrodes comprises a coplanar arrangement of at least one pair of electrodes.

31. Method according to any of the previous claims, wherein the electrodes of said at least one pair of electrodes are placed opposing each other.

32. Arrangement for generating an atmospheric pressure glow plasma (APG), comprising a discharge space formed between a plurality of electrodes for providing an electric field for generating a plasma, at least one of said electrodes comprising a dielectric attached such that a boundary surface between said dielectric and said discharge space is arranged for enabling interactions between said electric field and said surface, wherein said dielectric is arranged for releasing electrons contributing to said plasma from said surface by said interactions.

33. Arrangement according to claim 32, wherein said interactions between said electric field and said surface comprise interactions between said plasma and said surface.

34. Arrangement according to any of the claims 32 and 33, wherein said dielectric is contiguous to at least one electrode of said pair of electrodes, for providing electrons to said dielectric.

35. Arrangement according to any of the claims 32-34, wherein said dielectric comprises any substance of a group comprising triacetyl cellulose (TAC), polyethyleneterephthalate (PET), polyethylenenaphthalate (PEN), polytetrafluoroethylene (PTFE), ceramic such as SiO₂ or Al₂O₃, and combinations thereof.

36. Arrangement according to any of the claims 32-35, comprising means for establishing a gas flow within said discharge space.

37. Arrangement according to any of the claims 32-36, wherein said dielectric is removably attached to one of said electrodes.

38. Arrangement according to any of the claims 32-37, comprising means arranged for treating a substrate film with said plasma.

39. Arrangement according to any of the claims 32-38, wherein said boundary surface between said dielectric and said discharge space is maximized.

40. Arrangement according to any of the claims 32-39, wherein said plurality of electrodes comprises a coplanar arrangement of said plurality of electrodes.

41. Arrangement according to any of the claims 32-40, wherein at least two electrodes of said plurality of electrodes are placed opposing each other.
